# EUROPÄISCHE PATENTSCHRIFT

(11) **EP 3 647 456 B1**
(45) Veröffentlichungstag und Bekanntmachung des Hinweises auf die Patenterteilung: **17.03.2021**
(21) Anmeldenummer: 19206137.2
(22) Anmeldetag: 30.10.2019
(51) Int. Cl.: C23C 14/06, C25B 1/04, C25B 11/04, H01M 4/04, H01M 4/136, H01M 4/1397, H01M 10/0525, H01M 4/02, H01M 4/36, H01M 4/58, H01M 4/62

(54) **KATHODE UND EIN VERFAHREN ZUR HERSTELLUNG EINER KATHODE**
CATHODE AND METHOD FOR MANUFACTURING A CATHODE
CATHODE ET PROCÉDÉ DE FABRICATION D'UNE CATHODE

(30) Priorität: 02.11.2018 DE 102018127410
(43) Veröffentlichungstag der Anmeldung: 06.05.2020
(73) Patentinhaber: Technische Universität Darmstadt, 64289 Darmstadt (DE)
(72) Erfinder: Cherkashinin, Gennady, 64380 Roßdorf (DE); Jaegermann, Wolfram, 64823 Gross-Umstadt (DE)
(74) Vertreter: LifeTech IP Spies & Behrndt Patentanwälte PartG mbB

(56) Entgegenhaltungen:
- EP-A1- 3 322 009
- GENNADY CHERKASHININ ET AL: "Exploring redox activity in a LiCoPO 4 -LiCo 2 P 3 O 10 tailored positive electrode for 5 V lithium ion batteries: rigid band behavior of the electronic structure and stability of the delithiated phase", JOURNAL OF MATERIALS CHEMISTRY A, Bd. 6, Nr. 12, 1. Januar 2018 (2018-01-01) , Seiten 4966-4970, XP055649169, GB ISSN: 2050-7488, DOI: 10.1039/C7TA11161D
- GENNADY CHERKASHININ ET AL: "Toward Enhanced Electronic and Ionic Conductivity in Olivine LiCoPO 4 Thin Film Electrode Material for 5 V Lithium Batteries: Effect of LiCo 2 P 3 O 10 Impurity Phase", ADVANCED ENERGY MATERIALS, Bd. 7, Nr. 13, 21. Februar 2017 (2017-02-21), Seite 1602321, XP055649173, DE ISSN: 1614-6832, DOI: 10.1002/aenm.201602321

## Beschreibung

Die vorliegende Erfindung bezieht sich auf eine Kathode (oder auf ein Kathodenmaterial) und auf ein Verfahren zur Herstellung der Kathode und insbesondere auf eine Kathode mit einem hocheffizienten und stabilen Olivin-LiCoPO₄-Material, welches einen angepassten Zusatz von LiCo₂P₃O₁₀-Material aufweist, sodass es als Kathodenmaterial für Lithiumionen-Akkumulatoren und/oder als Katalysator für eine elektrochemische Oxidation von Wasser (OER = oxygen evolution reaction; Sauerstoffabgabenreaktion) geeignet ist.

### HINTERGRUND

Bisherige Materialien für Li-Ion Akkumulatoren für Laptops, Mobiltelefonie, Autos etc. sind meist LiFePO und LiCoO₂. Diese haben eine geringe Energiedichte, was zu hohem Bauraum und Gewicht führt.

Olivin-LiCoPO₄ (LCP; Lithium-Kobalt- Phosphat) ist ein weiteres bekanntes Kathodenmaterial für Lithiumionenbatterien, wie zum Beispiel in EP 3 322 009 A1. Es ist ebenfalls als ein Redoxaktives-Material mit einem Entladungspotential von ca. 4,8 V bekannt. Theoretisch ist damit eine sehr hohe Energiedichte von bis zu 816 Wh/kg für LCP-Batteriezellen möglich und ist daher für Batterien von elektrischen Fahrzeugen geeignet. Jedoch ist die gewerbliche Anwendung dadurch eingeschränkt, dass die Lithiumdiffusion und die elektrische Leitfähigkeit in diesen Olivin-Materialien noch unzureichend ist und zu einer schnellen Degradation von LCP-Batteriezellen während des Betreibens führt.

Die Dokumente Gennady Cherkashinin et al.,J. Mater. Chem. A, 2008, 6, pp 4966-4970, DOI: 10.1039/C7TA11161D und Gennady Cherkashinin et al., Adv. Energy Mater. 2017, 7, 1602321, DOI: 10.1002/aenm.201602321, beide vom selben Autor, offenbaren eine stabile und neue, elektronisch hochleitende Kathode für eine 5 V Lithium-Ionen Batterie auf der Basis von LiCoPO4-LiCo2P3O10, wobei im Zweiten die LiCo2P3O10-Phase als Verunreinigung bezeichnet ist.

Heutzutage gibt es noch keine gewerblich genutzte Olivin-LCP-Batteriezellen. Eine übliche Methode, die extrem schlechte elektrische Leitfähigkeitsperformanz von LCP zu überwinden, besteht in der chemischen Synthese von Nano-LCP-Teilchen und deren Mischung mit leitfähigem Kohlenstoff. Dies sind sogenannte LCP-Verbundmaterialien. Jedoch erhöht die Kohlenstoffbeschichtung von Olivin-Nanoteilchen nicht die elektrische Leitfähigkeit oder den chemischen Diffusionskoeffizienten von Lithium innerhalb der Kristallstruktur vom Olivin-Material.

Es gibt auch noch weitere Probleme bei der Nutzung von Kohlenstoff:
a) Kohlenstoff und Bindeteilchen stellen 10 bis 20% der Gesamtmasse des Verbundmaterials dar. Dies geht auf Kosten der Batteriekapazität.
b) Kohlenstoff bewirkt eine beträchtliche Reduzieratmosphäre, was zur Bildung von Metallphosphaten und/oder von Phosphocarbid-Phasen an der Korngrenze der Olivin-Teilchen führen kann.

Ein weiterer wesentlicher Nachteil bei der Nutzung von konventionellen Olivin-LCP besteht in der Amorphisierung bei Anwesenheit von Luft in einem vollständig Lithium-freien Zustand (delithiated state), der einem Ladezustand von ca. 5,1 V entspricht.

Es besteht ein Bedarf nach weiteren Kathodenmaterialien für effiziente und stabile elektrochemische Energiespeicher, insbesondere für Akkumulatoren hoher Energiedichte wie Hochleistungs-Lithium-Ionen Batterie. Ebenso besteht ein Bedarf nach aktiven Katalysatoren, die für eine elektrolytische Spaltung von Wasser einsetzbar sind.

### KURZBESCHREIBUNG DER ERFINDUNG

Zumindest ein Teil der obengenannten Probleme wird durch eine Kathode nach Anspruch 1 und ein Verfahren nach Anspruch 7 gelöst. Die abhängigen Ansprüche beziehen sich auf vorteilhafte Weiterbildungen der Gegenstände der unabhängigen Ansprüche.

Die vorliegende Erfindung bezieht sich auf eine Kathode (oder ein Kathodenmaterial) für eine Energiespeichereinrichtung oder für eine Elektrolyseeinrichtung. Die Kathode umfasst ein Substrat, eine körnige leitfähige Oberflächenschicht auf dem Substrat und eine Molybdän-Beschichtung oder Dotierung der körnige Oberflächenschicht. Die körnige Oberflächenschicht umfasst eine Mischung von LiCoPO₄-LiCo2P₃O₁₀ (LCP-LCPO).

Der Begriff Kathode soll breit ausgelegt werden, insbesondere aber eine Elektrode oder einen Teil davon umfassen, die beim Ladevorgang Lithium abgibt. Die Oberflächenschicht soll ebenfalls breit ausgelegt werden und alle Strukturen umfassen, die auf dem Substrat entlang einer seiner Außenflächen ausbildbar sind. Die Oberflächenschicht kann eine monotone Schichtdicke oder eine variable Schichtdicke haben und insbesondere eben, nichteben, rau, 3-dimensional strukturiert, grobkörnig etc. sein.

Optional umfasst das Substrat zumindest eines der folgenden Materialien: Si, TiN, Pt, Au oder andere elektrische leitfähige Materialien (z.B. Metalle) mit einer sauerstofffreien Oberfläche, um dort die körnige Oberflächenschicht auszubilden.

Optional ist die körnige Oberflächenschicht eine polykristalline Kombination einer Phase von Olivin-Lithium-Kobalt- Phosphat LiCoPO₄ mit einer LiCo₂P₃O₁₀ Phase (LCPO).

Optional umfasst die körnige Oberflächenschicht kleine und große Nanoteilchen. Die kleinen Nanoteilchen können in den große Nanoteilchen eingebettet sein, wobei die großen Nanoteilchen zumindest doppelt oder dreimal so groß sind wie die kleinen Nanoteilchen. Optional weist die körnige Oberflächenschicht eine durchschnittliche Schichtdicke in einem Bereich zwischen 100 nm bis 5.000 nm (oder zwischen 500 nm und 2.000 nm oder ca. 700 nm) auf.

Optional erlaubt die körnige Oberflächenschicht zumindest eine der folgenden (positiven) elektrischen Ladespannungen: 4,85 V, 4,9 V, 5,1 V, und zwar ohne dabei zu amorphisieren (die Schicht bleibt zum Beispiel polykristallin).

Ausführungsbeispiele beziehen sich auch auf eine Verwendung der Kathode bzw. des Kathodenmaterials, wie es zuvor beschrieben wurde, als eine Elektrode in einem Lithium-Ionen-Akkumulator oder als eine Elektrode für eine elektrolytisehe Wasserspaltung.

Ausführungsbeispiele beziehen sich auch auf ein Verfahren zur Herstellung einer Kathode für eine Batterie oder eine Elektrolyseeinrichtung. Das Verfahren umfasst die Schritte:
- Bereitstellen eines Substrats;
- Ausbilden eine Oberflächenschicht auf dem Substrat mit einer Mischung von LiCoPO₄-LiCo₂P₃O₁₀ (LCP-LCPO); und
- Beschichten der Oberflächenschicht mit Molybdänoxid oder Dotieren der Oberflächenschicht mit Molybdän.

Optional wird das Ausbilden des LCP-LCPO und/oder das Beschichten oder Dotieren durch zumindest eines der folgenden Beschichtungsverfahren ausgeführt: PVD, CVD, ALD. Hierunter fallen insbesondere die verschiedenen Sputter-Verfahren (sputtern = aufstäuben, aufschleudern).

Optional wird nach dem Ausbilden der Oberflächenschicht ein Ausheilprozess (oder Ausheizprozess) in einem Temperaturbereich zwischen 500°C - 1000°C (oder zwischen 675°C - 800°C) und/oder für eine Zeitdauer von 10 min bis 60 min (oder für ca. 30 min) und/oder eine Abkühlrate von 2°C/min - 20°C/min (oder zwischen 5°C und 10°C pro Minute) unter Luft ausgeführt, um eine Olivine-Kristallisierung zu erzeugen. Diese Bereiche können auch anders gewählt werden, wenn dadurch ebenfalls die gewünschte Olivin-Kristallisierung und die Bildung von LiCo₂P₃O₁₀ erreicht wird. Das Ausheilen des Kathodenmaterials von Zimmertemperatur (25 °C) bis 750 °C dauert beispielsweise 145 Minuten, unter Berücksichtigung dessen, dass der Schritt des Ausheilens mit beispielsweise 5°C pro Minute erfolgt. Anschließend verbleibt die Probe auf dieser Temperatur zwischen 10 und 60 Minuten(ungefähr 30 Minuten). Das Ausheilen oder Ausheizen benötigt bei höheren (bzw. niedrigeren) Temperaturen als 750 °C mehr (bzw. weniger) Zeit.

Optional wird das Ausbilden des LCP-LCPO und/oder das Beschichten der Oberflächenschicht in einer Vakuumkammer ausgeführt. Vakuumkammer kann ebenfalls eine Molybdän-Quelle aufweisen. Optional wird ein rostfreier Stahl, der in der Vakuumkammer vorhanden ist (z. B. ein Halter), als Molybdän-Quelle genutzt wird. Auf diese Weise kann mit dem Ausbilden der Oberflächenschicht gleichzeitig die Molybdän-Beschichtung der Oberflächenschicht erfolgen.

Ausführungsbeispiele lösen zumindest einen Teil der obengenannten Probleme durch eine Kombination von Lithium-Kobalt-Phosphoroxid-Phasen, und zwar LiCoPO₄ Phase (LCP) mit einer LiCo₂P₃O₁₀ Phase (LCPO). Dieses Material, was im Folgenden auch als angepasstes LCP-LCPO-Material bezeichnet wird, wird als ein dünner Film auf einem entsprechenden Substrat ausgebildet. Hierzu kann insbesondere die Hochfrequenzsputtertechnologie genutzt werden, wobei das LCP als Targetmaterial genutzt wird und auf ein leitfähiges Substrat aufgebracht wird. Als Substrat können beispielsweise Platin oder Platinfolien oder einkristallines Silizium genutzt werden, das mit Platin/Siliziumnitrid beschichtet ist. Als Substrat kann auch Platin/Titanoxid, das mit Siliziumoxid/Silizium genutzt werden. Wenn das Substrat selbst ein nichtleitfähiges oder nur schlecht leitfähiges Material aufweist, wird es mit einem gut elektrisch leitfähigen Material, insbesondere Metalle mit einer sauerstofffreien Oberfläche, beschichtet, um dort das LCP-LCPO-Material aufzubringen.

Insbesondere werden die Nachteile der konventionellen Materialien durch die zusätzliche Molybdänoxidschicht auf der Oberfläche des LCP-LCPO-Materials überwunden. Dies führt zu der gewünschten Erhöhung der Leitfähigkeit an der Oberfläche. Diese Molybdänoxidschicht fördert auch die Bildung einer großen Oberfläche durch eine hierarchische Struktur, bei der kleine Nanoteilchen in großen Teilchen eingebettet sind.

Das gewünschte LCP-LCPO-Material wird insbesondere durch das Ausheilen in Luft nach dem Aufbringen des LCP-Materials erzeugt, bei der die Olivin-LCP-Kristallstruktur der Pnma-Raumgruppensymmetrie erzeugen wird (die ICSD-Nummer 01-078-5576; ICSD = inorganic crystal structure database; die Kristallstrukturdatenbank des FIZ Karlsruhe). Außerdem wird dabei die LCPO-Phase mit der Raumsymmetriegruppe P21/m(11) als Kristallstruktur gebildet (die ICSD-Nummer 04-011-4098). Die Ausheilungsrate und die Dauer der Ausheilung werden bei einer bestimmten Temperatur derart gewählt, dass sich sowohl die Olivin-Struktur als auch die LCPO-Struktur in dem Material im Innern herausstellt.

Ausführungsbeispiele weisen die folgenden Vorteile auf:
- Zunächst überwinden Ausführungsbeispiele das Problem der geringen Leitfähigkeit und der Ionenleitfähigkeit von konventionellen LCP-Materialien im Innen durch ein angepasstes LCPO-Material.
- Die Verwendung von LCPO als aktives Redox-Material anstelle des elektrochemisch inaktiven, leitfähigen Kohlenstoffs erhöht die Energiedichte des Kathodenmaterials über die Teilnahme des LCPO-Materials an dem Redox-Prozess bei einem Ladungspotential von mehr als 5,1 V. Somit erhöht sich die gravimetrische Kapazität von LCP-LCPO-Batteriezellen durch das Ersetzen des Kohlenstoffes durch das elektrochemische aktive LCPO-Material.
- Das angepasste LCP-LCPO-Material wird mit einer Spannung von 5,1 V geladen, was dem vollständig Lithium-freien Zustand des LCP-Materials entspricht - im Gegensatz zu konventionellen Materialien, jedoch nicht in Gegenwart von Luft amorphisiert.
- Somit stabilisiert das LCPO-Material das gesamte Kathodenmaterial.
- Die Gitterparameter des vollständig mit Lithium befüllten Zustandes und des Lithium-freien Kathodenmaterials ändern sich nur wenig, was eine intrinsische hohe Stabilität des LCP-LCPO-angepassten Materials unter einem Redox-Prozess bedeutet.
- Die Leitfähigkeit an der Oberfläche des angepassten LCP-LCPO Materials erhöht sich durch die Beschichtung mit der Molybdänoxidschicht (MoOx) an der äußeren Oberfläche beträchtlich.
- Insbesondere bei der Verwendung LCP-LCPO als Batteriematerial (als Kathode in Li-Ion-Akkumulatoren) kann durch die Beschichtung mit Molybdänoxid auch eine höhere Energiedichte (J/m³) und höhere Leistungsdichte (W/m³) erreicht werden.

### KURZBESCHREIBUNG DER FIGUREN

Die Ausführungsbeispiele der vorliegenden Erfindung werden besser verstanden anhand der folgenden detaillierten Beschreibung und den beiliegenden Zeichnungen der unterschiedlichen Ausführungsbeispiele, die jedoch nicht so verstanden werden sollten, dass sie die Offenbarung auf die spezifischen Ausführungsformen einschränken, sondern lediglich der Erklärung und dem Verständnis dienen.
- Fig. 1: zeigt eine schematische Darstellung des Materials, welches gemäß Ausführungsbeispielen für eine Kathode eines Energiespeichers oder für eine Elektrolyseeinrichtungen eingesetzt wird.
- Fig. 2: zeigt eine LiCoPO₄ Olivin-Struktur (Einheitszelle), wie sie gemäß Ausführungsbeispielen genutzt wird.
- Fig. 3: zeigt ein Rasterelektronenmikroskopie-Bild des LCP-LCPO-Dünnschichtmaterials für die Kathode gemäß Ausführungsbeispielen.
- Fig. 4: zeigt zyklische Voltammogramme für verschiedene Ladezustände des Kathodenmaterials.
- Fig. 5: zeigt eine Änderung der Rötgenbeugungsreflexe für die verschiedenen Phasen im Kathodenmaterials.
- Fig. 6: zeigt eine schematische Ansicht der Ultrahochvakuum-Anlage zur Abscheidung der Dünnschichtkathodenmaterialien.
- Fig. 7: zeigt eine katalytische Aktivität in Bezug auf die elektrochemische Oxidation und veranschaulicht die Stabilität des Materials.

### DETAILLIERTE BESCHREIBUNG

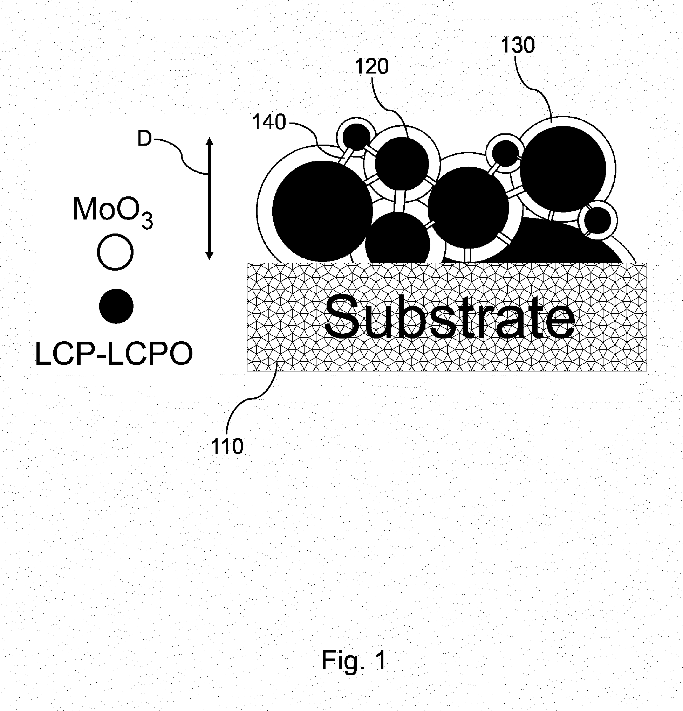

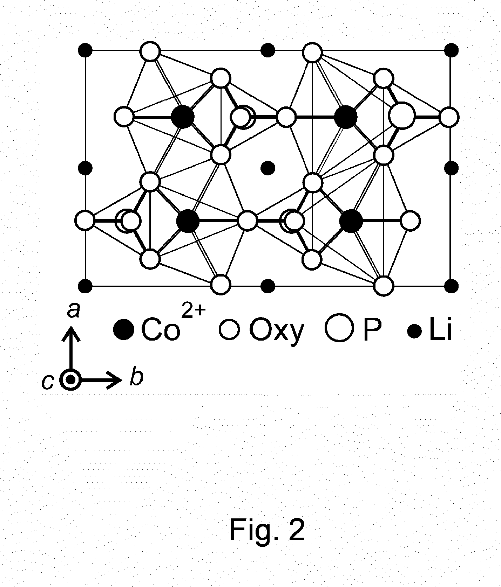

**Fig. 1** zeigt eine schematische Darstellung des Materials, welches gemäß Ausführungsbeispielen für eine Kathode eines Energiespeichers, insbesondere für eine Lithiumionen-Batterie, oder für eine Elektrolyseeinrichtung (z. B. zur elektrochemischen Oxidation von Wasser) geeignet ist. Das Material umfasst ein Substrat 110 mit einer Oberfläche 112, auf der eine Schicht aus angepasstem LCP-LCPO-Material 120 aufgebracht ist. Die Oberflächenbeschichtung 120 aus dem angepassten LCP-LCPO-Material hat dabei eine körnige Struktur und weist eine Olivin-Struktur auf (z. B. für die LCP-Phase; siehe Fig. 2 unten). Die körnige Struktur umfasst eine Vielzahl von Nanoteilchen, die beispielsweise einen Durchmesser in einem Bereich zwischen 1 nm und 50 nm oder zwischen 50 nm und 100 nm haben können, wobei insbesondere große und kleine Nanoteilchen vorhanden sind. Die kleinen Nanoteilchen sind in den großen Nanoteilchen eingebettet, wobei die großen Nanoteilchen zumindest doppelt oder dreimal oder viermal so groß sein können wie die kleinen Nanoteilchen. Dadurch wird eine hohe Packungsdichte erreicht.

Außerdem umfassen die Nanoteilchen aus dem LCP-LCPO-Material eine Oberflächenbeschichtung 130 aus Molybdänoxid (z. B. MoO₃). Die durchschnittliche Schichtdicke D des LCP-LCPO Materials 120 ist beispielsweise in einem Bereich zwischen 100 nm und 5.000 nm oder zwischen 500 nm und 2.000 nm (und beispielsweise ca. 700 nm). Die Nanoteilchen aus LCP-LCPO-Material sind beispielsweise über die leitfähige Brücken aus MoOₓ 140 miteinander verbunden.

Diese Molybdänoxidschicht 130 bietet den Vorteil, dass sie die Bildung einer großen Oberfläche durch eine hierarchische Struktur fördert, bei der die kleinen Nanoteilchen zwischen großen Nanoteilchen eingebettet sind. Außerdem steigt die Oberflächenleitfähigkeit und es ergibt sich ein besserer Kontakt zwischen dem Kollektor und dem Material. Die Materialleitfähigkeit kann auch ansteigen.

LCP-LCPO 120 als Kathodenmaterial kann mit unterschiedlichen Spannungen geladen werden: z. B. mit 4,85 V oder 4,9 V oder mit 5,1 V gegenüber Li+/Li. Ein Vorteil des Kathodenmaterials gemäß Ausführungsbeispielen besteht darin, dass kein leitfähiger Kohlenstoff nötig ist, sodass die elektrische Leitfähigkeit erhöht wird. Außerdem kann die Energiedichte des LCP-LCPO-Materials um bis zu 30 % (oder noch mehr) erhöht werden. Über die Einbeziehung des LiCo2P3O10 wird es möglich den Redox-Prozess bei einer höheren Spannung (ca. 5,2 V gegenüber Li+/Li) durchzuführen, wohingegen der Redox-Prozess bei dem LCP-Material bei ca. 4,8 V gegenüber Li+/Li abläuft.

Das LCP-LCPO-Material selbst braucht kein Lithium-Molybdänoxid (z.B. LixMoO3) aufzuweisen. Vielmehr ist das Molybdänoxid (MoOₓ; 2 <x <3) als Beschichtung auf das LCP-LCPO-Material 120 aufgebracht. Ebenso brauchen Ausführungsbeispiele keine Kohlenstoffbeschichtung aufzuweisen. Im Gegensatz zu konventionellen Materialien wird die Erhöhung der Leitfähigkeit durch die Kombination der LiCo2P3O10-Phase und der LiCoPO4-Phase erreicht. Das LiCoPO₄-LiCo2P₃O10/MoOx-System gemäß Ausführungsbeispielen kann als Kern-Struktur betrachtet werden, wobei die LiCoPO4-LiCo2P3O10-Polyphosphatteilchen Kerne sind, die mit einer anderen Komponente beschichtet sind, nämlich mit MoOx.

Eine weitere Möglichkeit, um die Leitfähigkeit in einem relativen Olivin-LiCoPO₄-Material zu erhöhen, besteht in einer Dotierung mit supervalenten Ionen (z.B. Mb, Zr, Ti, Mg, Al, B, Mo und Vanadium) als auch in der Bildung von metallisch angereicherten Phosphiden, die ein Perkolationsnetzwerk in dem LMPO_{4/}C (M=Fe, Ni) bilden.

Gemäß Ausführungsbeispielen können folgende Beschichtungsverfahren zum Einsatz kommen:
1) Physikalische Dampfabscheidungsverfahren (PVD):
   a) Kathodische Lichtbogenabscheidung (Arc-PVD),
   b) Elektronenstrahl-physikalische Dampfabscheidung (EBPVD),
   c) Verdampfung,
   d) gepulste Laserabscheidung (PLD),
   e) verschiedene Sputtertechniken: Ion Strahlsputtern (IBS), reaktives Sputtern, Ionen-unterstützte Abscheidung (IAD), Sputtern mit hohem Target-Einsatz (HiTUS), Hochleistungs-Impuls-Magnetron-Sputtern (HiPIMS), Gasflusssputtern.
2) Chemical Vapor Deposition (CVD), sowie die Kombination von CVD und PVD, die hybride physikalisch-chemische Gasphasenabscheidung (HPCVD) nennt.
3) Atomlagenabscheidung (ALD).

**Fig. 2** zeigt eine LiCoPO₄ Olivin-Struktur (Einheitszelle), die aus Kobalt, Sauerstoffphosphor und Lithium besteht und in der dargestellten Weise kristallisiert ist. Diese Olivin-Struktur wird durch eine anpasste Prozessführung erzeugt, die wie folgt gewählt werden kann.

Zunächst wird ein dünner Film 120 aus polykristallinem LCP-LCPO beispielsweise mit einer durchschnittlichen Schichtdicke von beispielsweise 700 nm (oder in einem Bereich von 300 nm bis 900 nm) auf eine Platinschicht als Substratmaterial aufgebracht. Dazu kann ein Hochfrequenz-Sputtern auf ein LiCo-PO-Targetmaterial genutzt werden. Die Dünnschicht 120 kann bei Raumtemperatur in einer Argon-Atmosphäre unter einem Argondruck von p = 1 ... 2 x 10⁻² mbar (der Druck kann jedoch im Bereich von 8 x 10⁻³ mbar bis 2 x 10⁻² mbar variieren) abgeschieden werden. Die Leistung des Magnetrons für das Sputtern kann in einem Bereich zwischen 1,3 und 3,0 W/cm² liegen. Eine niedrigere Leistung führt zu einer längeren Abscheidungszeit. Nach der Abscheidung der dünnen Schicht kann eine Ausheilung bei einer Temperatur in einem Bereich zwischen 500 °C - 1000°C (oder zwischen 675 - 800 °C) mit einer Rate von 5 bis 10 °C/min bei Luft erfolgen. Die Zeitdauer der Dünnschichtausheilung ist beispielsweise 30 Minuten lang. Diese Prozessführung führt zu einer Bildung von Olivin (siehe Fig. 2) und der LCPO-Kristallstrukturen in der Dünnschicht.

Die LCP-LCPO Dünnschicht 120 könnte auch mit einer größeren Schichtdicke (z.B. mehr als 1 µm) gebildet werden, wenn die Magnetrone der genutzte Sputterkammer das Abscheiden von Dünnschichtmaterialien für eine längere Zeit erlauben. Zum Beispiel könnte die Abscheidung durch ein senkrecht auf dem Substrat stehendes Magnetron 1,5 bis 2 Mal weniger Zeit brauchen als ein Magnetron mit der geneigten Geometrie, um eine gleiche Schichtdicke zu erreichen.

Die Wahl von Platin oder Platinfolien als Substratmaterial wurde wegen der chemischen Beständigkeit des Edelmetalls im Hinblick auf Oxidation gewählt, was zu einer stabilen Olivin-LCP- und LCPO-Struktur auf dem Substrat 110 während der Dünnschichtausbildung führt. Ein einkristalliner Wafer, beispielsweise Silizium, der mit einer Schutzschicht (TiO2, TiN, SiN etc.) und/oder mit einem Edelmetall (Pt, Au etc.) an der Oberseite beschichtet ist, kann auch als Substrat 110 für die LCP-LCPO-Dünnschicht 120 dienen. Die Oberfläche des Substrats 110 sollte rau sein (je höher die Rauheit, umso besser), was das Anhaften des LCP-LCPO-Films 120 an dem Substrat 110 erleichtert.

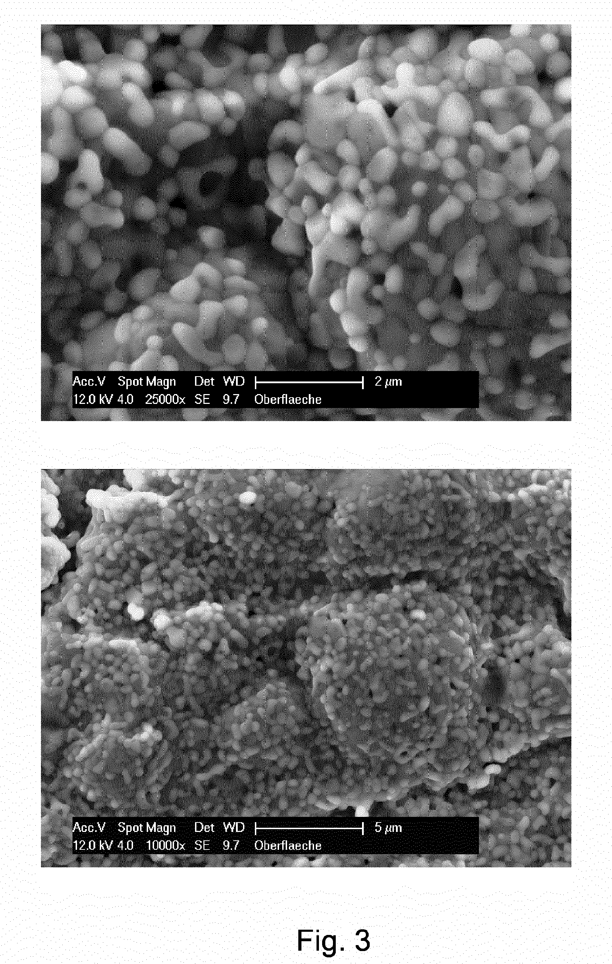

**Fig. 3** zeigt ein Rasterelektronenmikroskopie (REM) -Bild des LCP-LCPO-Dünnschichtmaterials für die Kathode gemäß Ausführungsbeispielen, wobei zwei verschiedene Auflösungen gezeigt sind: oben ist eine vergrößerte Auflösung zu sehen und unten eine geringere Auflösung. Wie in dem Bild unmittelbar erkennbar ist, weist die Kathode eine sehr große Oberfläche auf, die durch die körnige Struktur der LCP-LCPO-Schicht 120 verursacht wird. Ebenso sind die verschiedenen Größen der Nanoteilchen eindeutig aus dem Bild zu entnehmen.

Ein wesentlicher Nachteil von konventionellen LCPO-Kathodenmaterialien lag in dessen Neigung zur Armorphisierung im vollständig Lithium-freien Zustand (entsprechend dem 5,1 V Ladungszustand). Gemäß Ausführungsbeispiele stabilisiert jedoch die Gegenwart der LiCo₂P₃O₁₀ -Phase das LiCoPO₄ , sodass das Kathodenmaterial gemäß Ausführungsbeispielen (angepasstes LCP-LCPO-Material) bei einem Ladungszustand von 5,1 V nicht amorphisiert. Außerdem ändern sich die Gitterparameter des vollständig mit Lithium versetzten im Vergleich zum Lithium-freien Kathodenmaterials nur leicht, was auf eine hohe intrinsische Stabilität des LCP-LCPO angepassten Materials innerhalb einer Redoxreaktion hinweist, was ein weiterer Vorteil im Vergleich zu konventionellen LCP-Materialien darstellt.

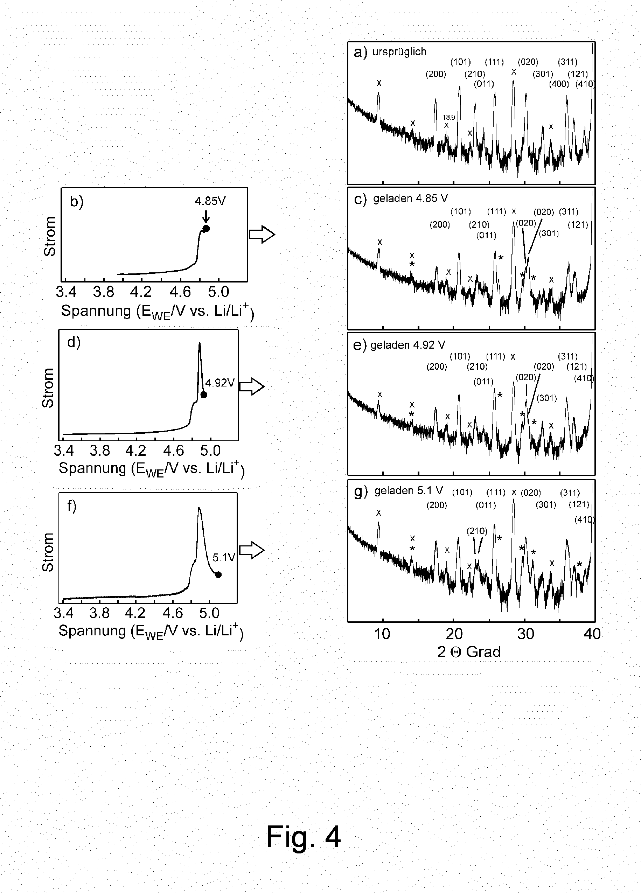

**Fig. 4** zeigt zyklische Voltammogramme (links) bei einem Ladezustand von 4,85 V (Darstellung b); 4,92 V (Darstellung d) und 5,1 V (Darstellung e), die als durchgezogener Kreise gezeigt sind. Die relevanten Röntgenbeugungs (XRD)-Muster sind rechts dargestellt.

In der Darstellung a) ist das XRD-Muster des "rohen" LCP-LCPO-Dünnfilmmaterials 120 (bei einer Ausheiltemperatur von T = 750 °C) gezeigt, indiziert auf Olivin LiCoPO₄ mit einer Pnma-Raumgruppensymmetrie (ICSD Nr. 01-078-5576). Die zweite kristallographische Phase (LiCo2P₃O10) der Raumgruppen-Symmetrie P21/*m* (11) (ICSD-Nr. 04-011-4098) ist durch Kreuze "x" gekennzeichnet.

In den Darstellungen c), e), g) sind die XRD-Muster des LCP-LCPO-Dünnschichtmaterials 120 (bei Ausheiltemperatur von T=700 °C) bei einem Ladungszustand von 4,85 V (Darstellung c); 4,92 V (Darstellung e) und 5,1 V (Darstellung g) gezeigt.

Aus den Darstellungen ist eindeutig zu entnehmen, dass die Olivin-Struktur (CoPO₄) und die Co2PO3O10-Phase selbst im vollständig Lithium-freien Material (bezeichnet als LiₓCP-LiₓCPO) erhalten bleiben. Der Übergang zur Co(PO₃)2-Phase (ICSD Nr. 00-027-1120) der I*/a (15C) - Raumgruppensymmetrie im Lithium-freien LCP-LCPO findet ebenfalls statt (dargestellt durch Sterne "*").

Da sich die Gitterparameter des vollständig mit Lithium befüllten und Lithium-freien Kathodenmaterials kaum ändern, weist das LCP-LCPO-Material eine hohe intrinsische Stabilität unter einem Redox-Prozess auf.

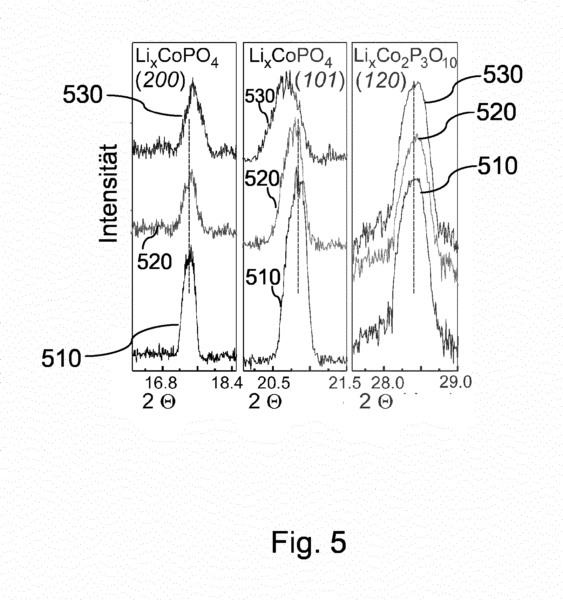

**Fig. 5** zeigt eine Änderung der Rötgenbeugungsreflexe (XRD-Reflexe) der Olivin-Phase (200), (101) und Dicobalt-Thripolyphosphat (120) im LCP-LCPO-Dünnschichtmaterial 120 unter verschiedenen Ladungspotentialen: im ursprünglichen Zustand (Graph 510); geladen mit 4.92 V (Graph 520) und geladen mit 5.1 V (Graph 530). Die (n, 1, 0) und (n, 1, c)-Reflexe haben sich bei einer Lithium-Freigabe in entgegengesetzte Richtungen verschoben (aufgrund einer Schrumpfung bzw. Erweiterung der (a, b) bzw. (c) Zellparameter).

Der höchste Intensitätsreflex (120) bei 2*θ* = 28,4° (für das Dikobalttripolyphosphat) verschwindet nicht im vollständig Lithium-freien Material (Graph 530), aber seine Halbwertsbreite ist leicht erhöht mit einer sehr geringen Positionsverschiebung zu höheren *θ* Werten (um ∼ 0,02°).

Die Analyse der Verschiebung der XRD-Peakpositionen unter Lithiumfreigabe des LCP-LCPO-Dünnfilms 120 zeigt, dass sich das (200)-Maximum der Olivin-Phase um ungefähr 0,2° zu einem höheren 2*θ* verschiebt, wenn das Kathodenmaterial auf ein Potenzial von 5,1 V geladen wird. Die Verbreiterung des Peaks und die damit verbundene Asymmetrie zeigen das Auftreten einer Lithium-freien Olivin-Phase.

Auf der anderen Seite ist die (1010)-Reflexion gleichzeitig zu niedrigerem 2*θ*-Wert verschoben, wenn das LCP-LCPO-Material auf ein Potential von 5,1 V geladen wird. Hieraus folgt, dass der 'a'-Gitterparameter (200) von LiₓCoPO₄ abnimmt, während die Lithiumabgabe einen Anstieg des 'c'-Gitterparameters bewirkt und zur beobachteten Vergrößerung des Abstandes der Ebenen der (101)-Peaks beiträgt. Dies ist in Übereinstimmung mit den Gitterparametern, die durch Rietveld-Verfeinerung erhalten werden und legt eine anisotrope Volumenkompression bei Lithiumentfernung nahe, wenn die Struktur (*Pnma*, LiₓCoPO₄) unverändert bleibt. Darüber hinaus wurden nur geringfügige Verschiebungen in der Position des (120) -Peaks vom LixCo₂P₃O₁₀ (+ 0.3° bei 5.1 V) beobachtet.

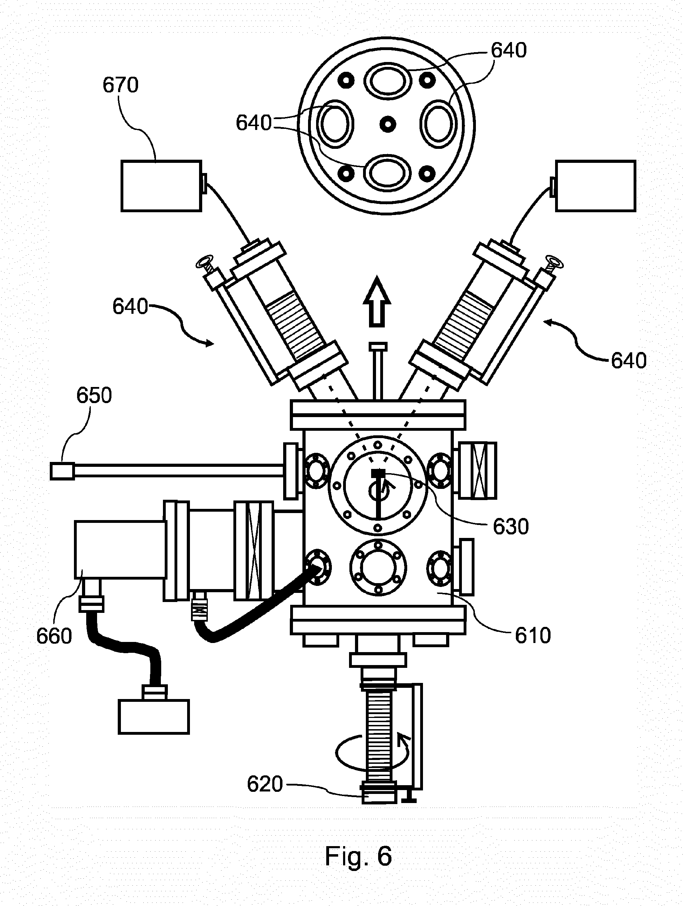

**Fig. 6** zeigt eine schematische Ansicht einer Ultrahochvakuum (UHV) - Anlage. Die Ultrahochvakuumkammer kann zur Beschichtung bzw. Herstellung des Kathodenmaterials gemäß Ausführungsbeispielen genutzt werden kann. Die Anlage umfasst eine Vakuumkammer 610 für eine Probe 630, die mittels eines Aktuators 620 drehbar ist. Die Probe 630 wird unter Nutzung von Magnetrone 640 beschichtet. Die Magnetrone 640 sind geneigt angeordnet. Außerdem umfasst die Anlage eine Probenwechseleinrichtung 650, die ausgebildet ist, um die Proben innerhalb der Kammer 610 zu wechseln. Die Anlage umfasst ferner eine Pumpe 660, die ein Vakuum innerhalb der Kammer 610 erzeugt. Die Magnetrone 640 werden über einen Generator und einen Impedanz-Anpasser 670 mit einem Hochfrequenzwelchselfeld versorgt, um die Teilchen auf die Probe 630 aufzusputtern.

In der Fig. 6 oben ist eine Draufsicht gezeigt, aus der ersichtlich ist, dass beispielhaft vier geneigt angeordnete Magnetrone vorhanden sein können, die jeweils 90° versetzt zueinander angeordnet sind.

Die gezeigte UHV-Anlage kann somit zum Beschichten/Dotieren des LCP-LCPO-Dünnschichtmaterials mit Molybdän genutzt werden. Die Erzeugung der Molybdänoxidschicht auf dem LCP-LCPO-Material kann auf einfache Weise unter Nutzung eines Probenhalters aus rostfreiem Stahl erreicht werden, da Molybdän eine übliche Komponente von rostfreiem Stahl ist. Das Ausheilen des Probenhalters in Luft führt zu einer Reaktion des Molybdäns mit dem Sauerstoff aus der Umgebung und das resultierende Molybdänoxid haftet an der LCP-LCPO-Oberfläche. Molybdän kann auch in tiefere Schichten des LCP-LCPO eindringen und dort das Material dotieren.

Im Fall der chemischen Synthese des LCP-LCPO-Materials kann das Molybdän auch als eine Vorstufe für die Beschichtung mit den LCP-Nanoteilchen hinzugefügt werden. Im Fall der chemischen Synthese von LCP oder LCP-LCPO kann das Grundmaterial/Ausgangsmaterial(Precursor) mit Molybdän dotiert sein..

Die Kohlenstoff-freien LCP-LCPO-Dünnschichten können als Kathodenmaterialien für Li-Ionen-Akkumulatoren genutzt werden. Dies wurde getestet mit den folgenden Testparametern/Bedingungen getestet:
1 M LiPF6 in 4:1 Gew./Gew. Dimethylcarbonat (DMC): fluoriertes Ethylencarbonat (EC) + 0,2 Gew.-% Trimethylboroxin (als Elektrolyt verwendet). Eine Li-Folie wurde als Anodenmaterial verwendet. Die zyklische Voltammetrie im Bereich von 3,1 V - 5,1 V -gegenüber Li+/Li wurde für die Prüfung der elektrochemischen Aktivität verwendet, wobei das mit MOₓ beschichtete LCP-LCPO-Dünnschichtkathodenmaterial die beste elektrochemische Aktivität zeigte.

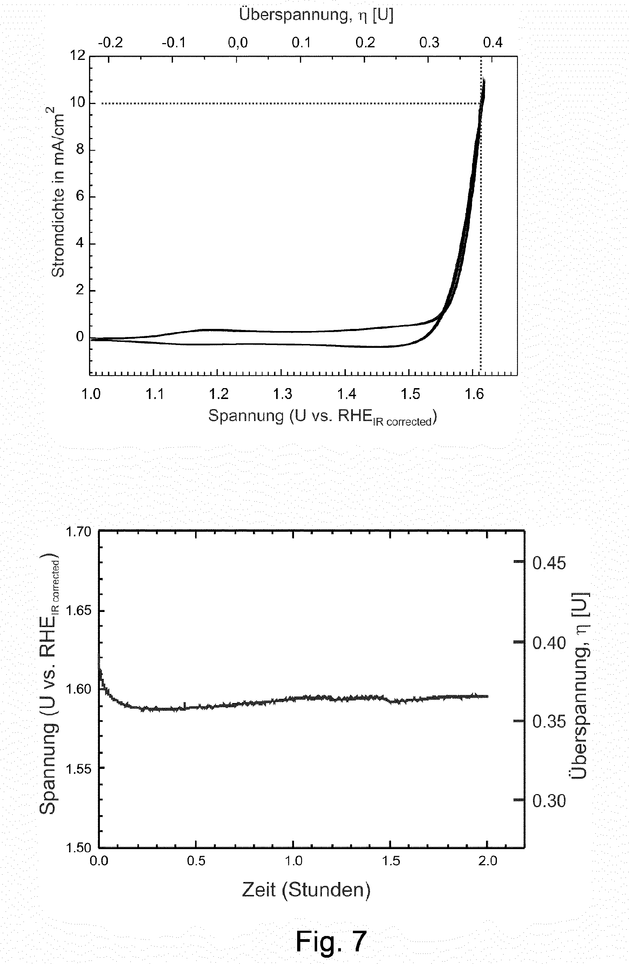

**Fig. 7** zeigt oben eine katalytische Aktivität in Bezug auf die elektrochemische Oxidation (OER) für das LCP-LCPO-Materials 120, das auf 5,1 V geladen ist (Lithium-freier Zustand). Eine Überspannung beträgt hierbei 370 mV, wobei die Überspannung als eine Potentialdifferenz zwischen dem thermodynamischen Redoxpotential einer Halbreaktion und demjenigen Potential definiert werden kann, bei der die Redox-Reaktion tatsächlich stattfindet. Das lithium-freie Kathodenmaterial zeigt daher eine katalytische Aktivität bei einer Stromdichte von ca. 10 mA/cm² bei einer Überspannung von ca. 370 mV. Die erreichbare katalytische Aktivität ist somit im Vergleich zu der Aktivität von konventionellem LCP-Material deutlich (z.B.Faktor >> 10) höher.

Das elektrochemische Lithium-freie LCP-LCPO-Filmmaterial wurde ebenfalls für die elektrolytische Wasserspaltung getestet. Die drei LCP-LCPO-Filme, die mit Potentialen von 5,1 V, 4,92 V und 4,85 V gegenüber Li+/Li geladen werden, wurden für diesen Zweck genutzt. Die Spannungswerte entsprechen dem Lithiumgehalt x in der Olivine-Struktur mit x∼0 für 5,1 V, x∼0,4 für 4,92 V, x∼0,6 für 4,85 V. Als Elektrolyt wurden dabei 0,1 M KOH, als Referenzelektrode Hg/HgO und Platindrähte als Gegenelektrode genutzt. Die Konditionierung wurde unter Nutzung einer zyklischen Voltammetrie in einem Spannungsbereich von 1,0 - 1,5 V gegenüber einer reversiblen Wasserstoffelektrode (RHE) durchgeführt. Die Stabilität wurde in einem Bereich zwischen 1,0 V - 1,9 V für 2 Stunden getestet (siehe Fig. 7 unten).

Daher kann das LCP-LCPO-Material nicht nur als Kathodenmaterial für Akkumulatoren eingesetzt werden, sondern auch zur Wasserspaltung (Elektrolyse) genutzt werden. Im Vergleich zu bisherigen Materialien können höhere Ströme (höhere Leistungsdichte) möglich und niedrigere Spannungen können genutzt werden.

Die in der Beschreibung, den Ansprüchen und den Figuren offenbarten Merkmale der Erfindung können sowohl einzeln als auch in beliebiger Kombination für die Verwirklichung der Erfindung wesentlich sein.

### BEZUGSZEICHENLISTE

- 110: Substrat
- 120: körnige Oberflächenschicht
- 130: Molybdän-Beschichtung
- 510,520,530: Röntgenbeugungsreflexe für verschiedene Ladungszustände
- 610: Vakuumkammer
- 620: Aktuators
- 630: Probe
- 640: Magnetrone
- 650: Probenwechseleinrichtung
- 660: Pumpe
- 670: Impedanz-Anpasser

## Patentansprüche

1. Kathode für eine Energiespeichereinrichtung oder für eine Elektrolyseeinrichtung, mit folgenden Merkmalen:
ein Substrat (110);
eine körnige leitfähige Oberflächenschicht (120) auf dem Substrat (110), wobei die körnige leitfähige Oberflächenschicht (120) eine Mischung von LiCoPO₄-LiCo2P₃O₁₀ (LCP-LCPO) aufweist; und
eine Molybdän-Beschichtung (130) oder Dotierung des LCP-LCPO.

2. Kathode nach Anspruch 1, wobei das Substrat (110) zumindest eines der folgenden Materialienaufweist: TiN, Pt, Au oder andere elektrisch leitfähige Materialen mit einer sauerstofffreien Oberfläche, wobei das Substrat optional mit Molybdän dotiert ist.

3. Kathode nach Anspruch 1 oder Anspruch 2, wobei die körnige Oberflächenschicht (120) eine polykristalline Kombination von Olivin-Lithium-Kobalt-Phosphat LiCoPO₄ mit einer LiCo₂P₃O₁₀ Phase (LCPO) ist.

4. Kathode nach einem der vorhergehenden Ansprüche, wobei die körnige Oberflächenschicht (120) kleine und große Nanoteilchen aufweist, wobei die kleinen Nanoteilchen in den große Nanoteilchen eingebettet sind und die großen Nanoteilchen zumindest doppelt oder dreimal so groß sind wie die kleinen Nanoteilchen und die körnige Oberflächenschicht (120) eine durchschnittliche Schichtdicke in einem Bereich zwischen 100 nm bis 5.000 nm aufweist.

5. Kathode nach einem der vorhergehenden Ansprüche, wobei die körnige Oberflächenschicht (120) zumindest eine der folgenden elektrischen Ladespannungen erlaubt, ohne dabei zu amorphisieren: 4,85 V, 4,9 V, 5,1 V gegenüber Li+/Li.

6. Verwenden der Kathode nach einem der vorhergehenden Ansprüche als eine Elektrode in einem Lithium-Ionen-Akkumulator oder als eine Elektrode für eine elektrolytische Wasserspaltung.

7. Verfahren zur Herstellung einer Kathode für eine Batterie oder eine Elektrolyseeinrichtung, mit folgenden Merkmalen:
Bereitstellen eines Substrats (110);
Ausbilden einer Oberflächenschicht (120) auf dem Substrat (110) mit einer Mischung von LiCoPO₄-LiCo₂P₃O₁₀ (LCP-LCPO); und
Beschichten der Oberflächenschicht (120) mit Molybdänoxid oder Dotieren der Oberflächenschicht (120) mit Molybdän.

8. Verfahren nach Anspruch 7, wobei das Ausbilden der Oberflächenschicht (120) und/oder das Beschichten oder Dotieren durch zumindest eines der folgenden Beschichtungsverfahren ausgeführt wird: PVD, CVD, ALD.

9. Verfahren nach Anspruch 7 oder Anspruch 8, wobei nach dem Ausbilden der Oberflächenschicht (120) ein Ausheilprozess in einem Temperaturbereich zwischen 500°C - 1000°C und eine optionale Abkühlrate in einem Bereich von 2°C bis 20°C pro Minute für eine Zeitdauer zwischen 10 min und 60 min unter Luft erfolgt, um eine Olivine-Kristallisierung zu erzeugen.

10. Verfahren nach einem der Ansprüche 7 bis 9, wobei das Ausbilden der Oberflächenschicht (120) und/oder das Beschichten der Oberflächenschicht (120) in einer Vakuumkammer (610) ausgeführt wird, die eine Molybdän-Quelle aufweist.

11. Verfahren nach einem der Ansprüche 7 bis 9, wobei das Ausbilden der Oberflächenschicht (120) und/oder das Beschichten der Oberflächenschicht (120) in einem Ofen ausgeführt wird, wobei ein mit Molybdän dotiertes Ausgangsmaterial genutzt wird und ein Ausheilen in einer Luftumgebung erfolgt.

12. Verfahren nach Anspruch 10, wobei ein rostfreier Stahl, der in der Vakuumkammer (610) vorhanden ist, als Molybdän-Quelle genutzt wird, sodass mit dem Ausbilden der Oberflächenschicht (120) gleichzeitig die Molybdän-Beschichtung der Oberflächenschicht (120) erfolgt.

13. Verfahren nach einem der Ansprüche 7 bis 12, wobei das Ausgangsmaterial mit Molybdän dotiert ist.

## Claims

1. Cathode for an energy storage device or for an electrolysis device, the cathode comprising the following features:
a substrate (110);
a granular conductive surface layer (120) on the substrate (110), wherein the granular conductive surface layer (120) comprises a mixture of LiCoPO₄-LiCo₂P₃O₁₀ (LCP-LCPO); and
a molybdenum coating (130) or doping of the LCP-LCPO.

2. Cathode according to claim 1, wherein the substrate (110) comprises at least one of the following materials:
TiN, Pt, Au or other electrically conductive materials that have an oxygen-free surface, wherein the substrate is optionally doped with molybdenum.

3. Cathode according to either claim 1 or claim 2, wherein the granular surface layer (120) is a polycrystalline combination of olivine-lithium-cobalt-phosphate LiCoPO₄ with an LiCo₂P₃O₁₀ phase (LCPO).

4. Cathode according to any of the preceding claims, wherein the granular surface layer (120) comprises small and large nanoparticles, wherein the small nanoparticles are embedded in the large nanoparticles and the large nanoparticles are at least twice or three times as large as the small nanoparticles and the granular surface layer (120) has an average layer thickness in a range between 100 nm and 5,000 nm.

5. Cathode according to any of the preceding claims, wherein the granular surface layer (120) allows at least one of the following electrical charging voltages without amorphizing: 4.85 V, 4.9 V, 5.1 V versus Li⁺/Li.

6. Use of the cathode according to any of the preceding claims as an electrode in a lithium-ion battery or as an electrode for electrolytically separating water.

7. Method for producing a cathode for a battery or an electrolysis device, the method comprising the following features:
providing a substrate (110);
forming a surface layer (120) on the substrate (110) using a mixture of LiCoPO₄-LiCO₂P₃O₁₀ (LCP-LCPO); and
coating the surface layer (120) with molybdenum oxide or doping the surface layer (120) with molybdenum.

8. Method according to claim 7, wherein the formation of the surface layer (120) and/or the coating or doping is carried out using at least one of the following coating methods: PVD, CVD, ALD.

9. Method according to either claim 7 or claim 8, wherein, after the surface layer (120) has been formed, an annealing process is carried out under air in a temperature range between 500 °C and 1000 °C and at an optional cooling rate in a range of 2 °C to 20 °C per minute for a time period between 10 min and 60 min in order to generate an olivine crystallization.

10. Method according to any of claims 7 to 9, wherein the surface layer (120) is formed and/or the surface layer (120) is coated in a vacuum chamber (610) which has a molybdenum source.

11. Method according to any of claims 7 to 9, wherein the surface layer (120) is formed and/or the surface layer (120) is coated in a furnace, wherein a starting material doped with molybdenum is used and annealing is carried out in an air environment.

12. Method according to claim 10, wherein a stainless steel which is present in the vacuum chamber (610) is used as a molybdenum source, such that the surface layer (120) is coated with molybdenum at the same as time as the surface layer (120) is formed.

13. Method according to any of claims 7 to 12, wherein the starting material is doped with molybdenum.

## Revendications

1. Cathode destinée à un dispositif de stockage d'énergie ou à un dispositif d'électrolyse, comportant les caractéristiques suivantes :
un substrat (110) ;
une couche de surface conductrice granulaire (120) sur le substrat (110), la couche de surface conductrice granulaire (120) comportant un mélange de LiCoPO₄-LiCO₂P₃O₁₀ (LCP-LCPO) ; et
un revêtement de molybdène (130) ou un dopage du LCP-LCPO.

2. Cathode selon la revendication 1, dans laquelle le substrat (110) comporte au moins l'un des matériaux suivants :
TiN, Pt, Au ou d'autres matériaux électriquement conducteurs à surface sans oxygène, le substrat étant éventuellement dopé au molybdène.

3. Cathode selon la revendication 1 ou la revendication 2, dans laquelle la couche de surface granulaire (120) est une combinaison polycristalline d'olivine-lithium-cobalt-phosphate LiCoPO₄ comportant une phase LiCo₂P₃O₁₀ (LCPO).

4. Cathode selon l'une des revendications précédentes, dans laquelle la couche de surface granulaire (120) comporte des petites nanoparticules et des grosses nanoparticules, les petites nanoparticules étant noyées dans les grosses nanoparticules et les grosses nanoparticules étant au moins deux ou trois fois plus grosses que les petites nanoparticules et la couche de surface granulaire (120) comportant une épaisseur de couche moyenne comprise entre 100 nm et 5 000 nm.

5. Cathode selon l'une des revendications précédentes, dans laquelle la couche de surface granulaire (120) permet au moins l'une des tensions de charge électrique suivantes, sans amorphisation :
4,85 V, 4,9 V, 5,1 V par rapport au Li⁺/Li.

6. Utilisation de la cathode selon l'une des revendications précédentes comme électrode dans un accumulateur lithium-ion ou comme électrode destinée à la séparation électrolytique de l'eau.

7. Procédé de production d'une cathode destinée à une batterie ou à un dispositif d'électrolyse, comportant les caractéristiques suivantes :
mise à disposition d'un substrat (110) ;
formation d'une couche de surface (120) sur le substrat (110) avec un mélange de LiC0PO₄-LiCo₂P₃O₁₀ (LCP-LCPO) ; et
revêtement de la couche de surface (120) avec de l'oxyde de molybdène ou dopage de la couche de surface (120) avec du molybdène.

8. Procédé selon la revendication 7, dans lequel la formation de la couche de surface (120) et/ou le revêtement ou le dopage sont réalisés par au moins l'un des procédés de revêtement suivants :
PVD, CVD, ALD.

9. Procédé selon la revendication 7 ou la revendication 8, dans lequel, après la formation de la couche de surface (120), un processus de recuit est effectué dans une plage de températures comprise entre 500 °C et 1 000 °C et à une vitesse de refroidissement facultative dans une plage de 2 °C à 20 °C par minute pendant une période de temps comprise entre 10 min et 60 min sous air, afin de produire une cristallisation d'olivine.

10. Procédé selon l'une des revendications 7 à 9, dans lequel la formation de la couche de surface (120) et/ou le revêtement de la couche de surface (120) sont réalisés dans une chambre à vide (610) qui comporte une source de molybdène.

11. Procédé selon l'une des revendications 7 à 9, dans lequel la formation de la couche de surface (120) et/ou le revêtement de la couche de surface (120) sont réalisés dans un four, un matériau de départ dopé au molybdène étant utilisé et un recuit étant effectué dans un environnement aérien.

12. Procédé selon la revendication 10, dans lequel un acier inoxydable qui est présent dans la chambre à vide (610) est utilisé comme source de molybdène, de sorte que le revêtement de la couche de surface (120) avec du molybdène est effectué en même temps que la formation de la couche de surface (120).

13. Procédé selon l'une des revendications 7 à 12, dans lequel le matériau de départ est dopé avec du molybdène.
